# EUROPEAN PATENT APPLICATION

(11) **EP 4 141 975 A1**
(43) Date of publication of application: **01.03.2023**
(21) Application number: 21825163.5
(22) Date of filing: 11.06.2021
(51) Int. Cl.: H01L 33/52, H01L 33/48, H01L 33/44, H01L 25/075, H01L 27/15, H01L 33/00

(54) **LIGHT-EMITTING MODULE HAVING PLURALITY OF UNIT PIXELS, METHOD FOR MANUFACTURING SAME, AND DISPLAY DEVICE HAVING SAME**

(30) Priority: 18.06.2020 US 202063040782 P; 23.09.2020 US 202063082118 P; 07.06.2021 US 202117340951
(71) Applicant: Seoul Semiconductor Co., Ltd., Gyeonggi-do 15429 (KR)
(72) Inventor: PARK, Jae Hyun, Ansan-Si, Gyeonggi-do 15429 (KR); HONG, Seung Sik, Ansan-Si, Gyeonggi-do 15429 (KR)
(74) Representative: Stolmár & Partner Patentanwälte PartG mbB
(86) International application number: PCT/KR2021/007355
(87) International publication number: WO 2021/256787

(57) **Abstract**

A method for manufacturing a light-emitting module, according to one embodiment of the present disclosure, comprises: mounting a plurality of unit pixels on a circuit board; applying a molding material so as to cover the unit pixels; arranging a plate on the molding material so as to press the molding material by means of the plate; and curing the molding material so as to form a molding part.

## Description

### [Technical Field]

Exemplary embodiments relate to a light emitting module having a plurality of unit pixels, a method of fabricating the same, and a displaying apparatus having the same, and more particularly, to a light emitting module including a molding layer for protecting the unit pixels.

### [Background Art]

Light emitting devices are semiconductor devices using light emitting diodes which are inorganic light sources, and are used in various technical fields such as displaying apparatuses, automobile lamps, general lighting, and the like. Light emitting diodes have advantages such as longer lifespan, lower power consumption, and quicker response, than conventional light sources, and thus, the light emitting diodes have been replacing the conventional light sources.

The conventional light emitting diodes have been generally used as backlight light sources in displaying apparatuses. However, displaying apparatuses that directly realize images using the light emitting diodes have been recently developed. Such displays are also referred to as micro LED displays.

In general, the displaying apparatus displays various colors through mixture of blue, green, and red light. In order to realize various images, the displaying apparatus includes a plurality of pixels, each including sub-pixels corresponding to one of blue, green, and red light. As such, a color of a certain pixel is typically determined based on the colors of the sub-pixels, so that images can be realized through the combination of such pixels.

In the case of the micro LED display, a micro LED is arranged on a two-dimensional plane corresponding to each sub pixel, and, accordingly, a large number of micro LEDs need to be arranged on a single substrate. However, the micro LED is extremely small, for example, 200 µm or less, further 100 µm or less, and these small sizes may cause various drawbacks In particular, it may be difficult to handle the light emitting diodes having small sizes, and thus, it is not easy to directly mount the light emitting diodes on a display panel.

In particular, when the micro LEDs are directly mounted on a display substrate, a yield of the displaying apparatus is lowered, and it is difficult to repair defects that occur during mounting. Accordingly, techniques of manufacturing sub-pixels as one unit pixel, further integrating a plurality of unit pixels into one light emitting module, and mounting these light emitting modules on the display substrate have been used.

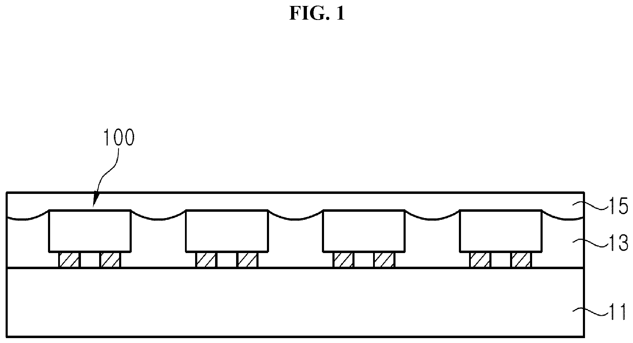

FIG. 1 is a cross-sectional view illustrating a conventional light emitting module including a plurality of unit pixels.

Referring to FIG. 1, the light emitting module includes a circuit board 11, a plurality of unit pixels 100, a first molding member 13, and a second molding member 15.

The circuit board 11 has circuits for supplying power to the unit pixels 100. In addition, the circuit board 11 may have pads for mounting the unit pixels 100 on an upper surface thereof, and may have pads for being mounted on a display substrate on a lower surface thereof.

The unit pixel 100 includes a plurality of sub-pixels, and each of the sub-pixels includes micro LEDs. The unit pixel 100 may include sub-pixels that emit blue, green, and red light, for example. The unit pixels 100 may be bonded to the circuit board 11 through a bonding material such as solder.

The first molding member 13 covers side surfaces of the unit pixels 100. The first molding member 13 may be formed of a thermosetting resin including a light absorbing agent, for example, epoxy or silicone, to block light.

The second molding member 15 may cover the unit pixels 100 and the first molding member 13. The second molding member 15 may also be formed of a transparent thermosetting resin, for example, epoxy or silicone.

As the first molding member 13 is formed by dispensing a resin, it is difficult to prevent formation of a concave portion in a region between the unit pixels 100 as shown in FIG. 1. The concave portions formed in the first molding member 13 make light emitted from the unit pixels 100 non-uniform. A light exiting surface may be flattened using the transparent second molding member 15, but since a surface of the first molding member 13 including the light absorbing agent is not flat, a light absorption difference may occur depending on locations of the unit pixels 100, and thus, light may be unevenly emitted.

In addition, as the first and second molding members 13 and 15 are formed of the thermosetting resin, it is difficult to increase hardness of the first and second molding members 13 and 15. Accordingly, it is difficult to protect the unit pixels 100 from an external force.

Mold technology may be used to form the first molding member 13 flat, but since the mold technology is generally used at high temperatures and high pressures, damage due to stress is likely to occur and a drawback such as delamination occurs. In addition, it may not be suitable for mass production.

Although the first molding member 13 may be formed by attaching a film, the film is likely to be lifted and defects such as irregularities may occur due to a pressing process.

### [Disclosure of Invention]

### [Technical Problem]

Exemplary embodiments provide a light emitting module having a uniform light exiting surface and a method of fabricating the same.

Exemplary embodiments provide a light emitting module having a molding member having a relatively high hardness, and a method of fabricating the same.

Exemplary embodiments provide a method of fabricating a light emitting module capable of easily implement a light-absorbing molding member or a transparent molding member, and suitable for mass production.

### [Technical Solution]

Exemplary embodiments provide a method of fabricating a light emitting module including mounting a plurality of unit pixels on a circuit board, applying a molding material to cover the unit pixels, placing a plate on the molding material to press the molding material with the plate, and curing the molding material to form a molding member.

Exemplary embodiments provide a light emitting module including a circuit board, unit pixels mounted on the circuit board, a molding member covering the unit pixels, and an anti-glare layer disposed on the molding member. A side surface of the circuit board, a side surface of the molding member, and a side surface of the anti-glare layer are flush with one another.

Exemplary embodiments provide a displaying apparatus including a display substrate, and a plurality of light emitting modules arranged on the display substrate, each of the light emitting modules including a circuit board, unit pixels mounted on the circuit board, a molding member covering the unit pixels, and an anti-glare layer disposed on the molding member. A side surface of the circuit board, a side surface of the molding member, and a side surface of the anti-glare layer are flush with one another.

### [Description of Drawings]

FIG. 1 is a cross-sectional view illustrating a conventional light emitting module including a plurality of unit pixels.
FIG. 2A is a schematic plan view illustrating a displaying apparatus according to an exemplary embodiment.
FIG. 2B is a schematic cross-sectional view taken along line A-A' of FIG. 2A.
FIG. 3A is a schematic plan view illustrating a light emitting module according to an exemplary embodiment.
FIG. 3B is a schematic cross-sectional view taken along line B-B' of FIG. 3A.
FIG. 4A is a schematic plan view illustrating a unit pixel according to an exemplary embodiment.
FIG. 4B is a schematic cross-sectional view taken along line C-C' of FIG. 4A.
FIG. 5A is a schematic plan view illustrating a light emitting device according to an exemplary embodiment.
FIG. 5B is a schematic cross-sectional view taken along line D-D' of FIG. 5A.
FIG. 6A is a schematic plan view illustrating a unit pixel according to another exemplary embodiment.
FIG. 6B is a schematic cross-sectional view taken along line E-E' of FIG. 6A.
FIGS. 7A through 7F are schematic cross-sectional views illustrating a method of fabricating a light emitting module according to an exemplary embodiment, where: FIG. 7A illustrates bonding unit pixels on a circuit board; FIG. 7B illustrates forming a dam near an edge of the circuit board; FIG. 7C illustrates forming a preliminary molding member; FIG. 7D illustrates placing a plate on the preliminary molding member; FIG. 7E illustrates removing the plate and forming an anti-glare layer; and FIG. 7F illustrates cutting and removing edges of the circuit board including the dam.
FIGS. 8A through 8D are schematic cross-sectional views illustrating a method of fabricating a light emitting module according to another exemplary embodiment, where: FIG. 8A illustrates bonding unit pixels to a circuit board; FIG. 8B illustrates placing a plate on a preliminary molding member; FIG. 8C illustrates forming an anti-glare layer; and FIG. 8D illustrates cutting and removing an edge of the circuit board.
FIG. 9A illustrates a schematic plan view illustrating a light emitting module having a continuous dam structure according to an exemplary embodiment.
FIG. 9B illustrates a schematic plan view illustrating a light emitting module having a discontinuous dam structure according to another exemplary embodiment.

### [Mode for Invention]

Hereinafter, embodiments will be described in detail with reference to the accompanying drawings. The following embodiments are provided by way of example so as to fully convey the spirit of the present disclosure to those skilled in the art to which the present disclosure pertains. Accordingly, the present disclosure is not limited to the embodiments disclosed herein and can also be implemented in different forms. In the drawings, widths, lengths, thicknesses, and the like of elements can be exaggerated for clarity and descriptive purposes. When an element or layer is referred to as being "disposed above" or "disposed on" another element or layer, it can be directly "disposed above" or "disposed on" the other element or layer or intervening elements or layers can be present. Throughout the specification, like reference numerals denote like elements having the same or similar functions.

Exemplary embodiments provide a method of fabricating a light emitting module includes mounting a plurality of unit pixels on a circuit board, applying a molding material to cover the unit pixels, placing a plate on the molding material to press the molding material with the plate, and curing the molding material to form a molding member.

Since the plate is used, it is possible to form the molding member having a uniform upper surface.

The method may further include forming a dam on the circuit board prior to applying the molding material. Since the dam is used, loss of the molding material may be reduced, and a thickness of the molding member may be precisely controlled.

In an exemplary embodiment, the dam may be disposed to surround the unit pixels. In another exemplary embodiment, the dam may be disposed along an edge of the circuit board discontinuously at a predetermined interval to form a dotted line shape.

In another variant, the molding material may be cured using ultraviolet rays. Since a UV curable molding material is employed, it is possible to form the molding member having a high hardness.

The molding material may include an acrylic resin, a silicone resin, or a urethane resin.

Further, the molding material may include a light absorbing agent or a dye.

The plate may have a nano-pattern or a micro-pattern on a lower surface thereof.
Accordingly, the nano pattern or the micro pattern corresponding to an upper surface of the molding member may be formed.

The method of fabricating the light emitting module may further include forming an anti-glare layer on the molding member. Since the anti-glare layer is formed, it is possible to reduce a user's eye fatigue.

The anti-glare layer may include an acrylic, silicone, or urethane resin and fine particles spread in the resin.

In an exemplary embodiment, the unit pixels may include at least three light emitting devices arranged on a same plane.

In another exemplary embodiment, the unit pixels may include a first LED stack, a second LED stack, and a third LED stack stacked in a vertical direction.

Further, the second LED stack may be disposed between the first LED stack and the third LED stack, and may emit light having a shorter wavelength than those of the first and third LED stacks.

The unit pixels may be bonded to the circuit board through a reflow process.

In addition, each of the unit pixels may include four pads.

The molding member may have a uniform upper surface over the unit pixels and over a region between the unit pixels.

The method of fabricating the light emitting module may further include removing the dam by cutting the molding member and the circuit board.

A light emitting module according to an exemplary embodiment includes: a circuit board; unit pixels mounted on the circuit board; a molding member covering the unit pixels, and an anti-glare layer disposed on the molding member, in which a side surface of the circuit board, a side surface of the molding member, and a side surface of the anti-glare layer are flush with one another.

In at least one variant, the molding member may be formed of a uniform material, and may have a uniform upper surface over the unit pixels and over a region between the unit pixels.

Exemplary embodiments provide a displaying apparatus, the displaying apparatus including a display substrate, and a plurality of light emitting modules arranged on the display substrate. Each of the light emitting module includes a circuit board, unit pixels mounted on the circuit board, a molding member covering the unit pixels, and an anti-glare layer disposed on the molding member. A side surface of the circuit board, a side surface of the molding member, and a side surface of the anti-glare layer are flush with one another.

Hereinafter, exemplary embodiments will be described in detail with reference to the accompanying drawings

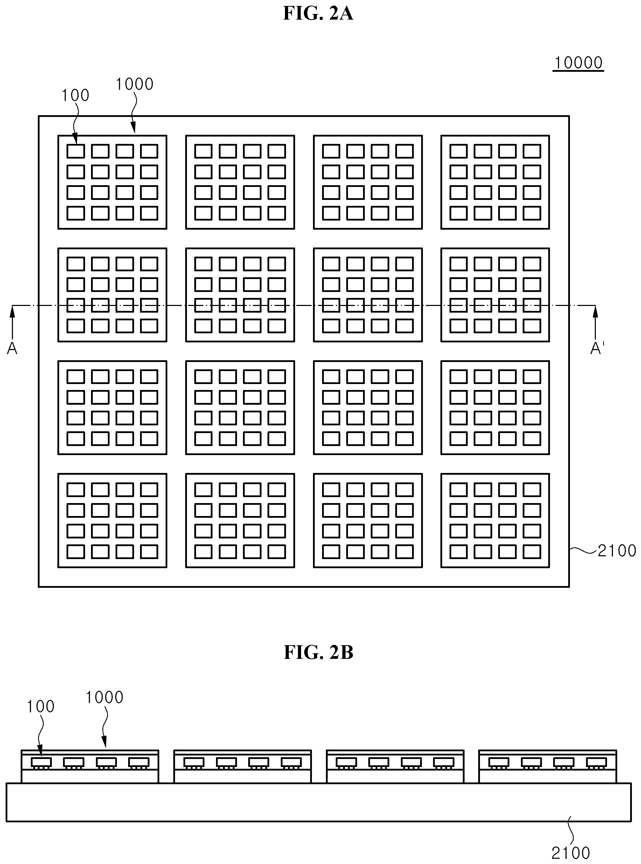

FIG. 2A is a schematic plan view illustrating a displaying apparatus according to an exemplary embodiment, and FIG. 2B is a schematic cross-sectional view taken along line A-A' of FIG. 2A.

Referring to FIGS. 2A and 2B, a displaying apparatus 10000 may include a panel substrate 2100 and a plurality of light emitting modules 1000.

The displaying apparatus 10000 is not particularly limited, but it may include a VR displaying apparatus such as a micro LED TV, a smart watch, a VR headset, or an AR displaying apparatus such as augmented reality glasses.

The panel substrate 2100 may include a circuit for a passive matrix driving or an active matrix driving circuit. In some forms, the panel substrate 2100 may include wirings and resistors therein, and, in another form, the panel substrate 2100 may include wirings, transistors, and capacitors. The panel substrate 2100 may also have pads that are capable of being electrically connected to the disposed circuit on an upper surface thereof.

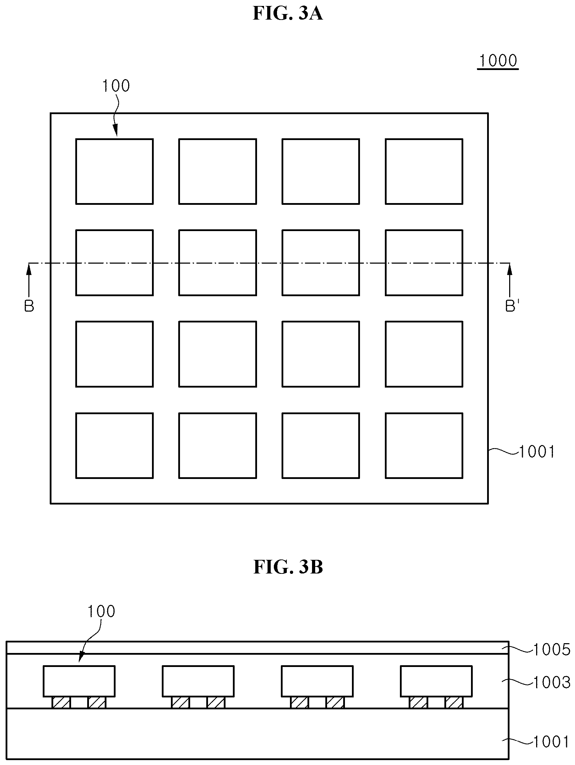

In an exemplary embodiment, the plurality of light emitting modules 1000 are arranged on the panel substrate 2100. Each of the light emitting modules 1000, as shown in FIG. 3A, may include a circuit board 1001 and a plurality of unit pixels 100 disposed on the circuit board 1001. Each of the unit pixels 100 includes a plurality of light emitting devices. The light emitting devices may emit light of different colors from one another.

Hereinafter, each element of the displaying apparatus 10000 will be described in detail in an order of the light emitting module 1000 disposed in the displaying apparatus 10000, the unit pixels 100 arranged in the light emitting module 1000, and the light emitting devices.

FIG. 3A is a schematic plan view illustrating a light emitting module 1000 according to an exemplary embodiment, and FIG. 3B is a schematic cross-sectional view taken along line B-B' of FIG. 3A.

Referring to FIGS. 3A and 3B, the light emitting module 1000 may further includes a circuit board 1001, unit pixels 100 arranged on the circuit board 1001, and a molding member 1003 covering the unit pixels 100, and an anti-glare layer 1005.

The circuit board 1001 may have a circuit for electrically connecting a panel board 2100 and the unit pixels 100. The circuit in the circuit board 1001 may be formed in a multilayer structure. The circuit board 1001 may also include a passive circuit for driving the unit pixels 100 in a passive matrix driving manner or an active circuit for driving the unit pixels 100 in an active matrix driving manner. The circuit board 1001 may have pads exposed on a surface thereof, and the unit pixels 100 may be bonded to the pads of the circuit board 1001 through a bonding material.

The unit pixels 100 may be arranged on the circuit board 1001. The unit pixels 100 may be arranged in a 4×4 matrix as shown in FIG. 3A, but the inventive concepts are not limited thereto, and may be arranged in various matrices such as 2×2, 3×3, 5×5, or the like.

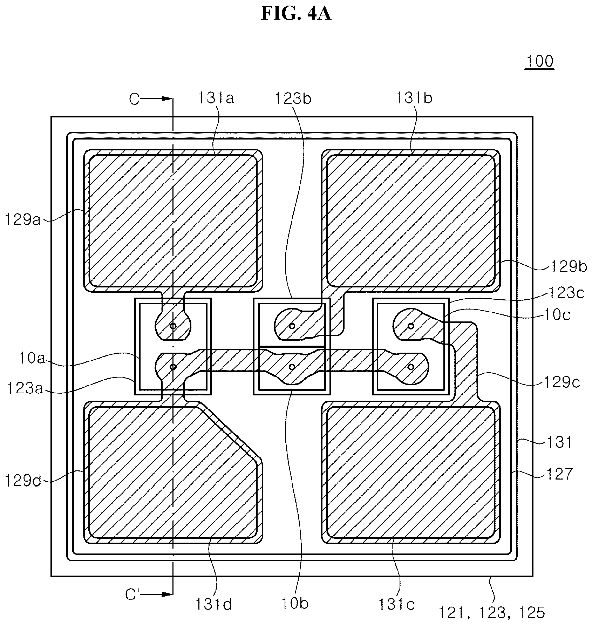

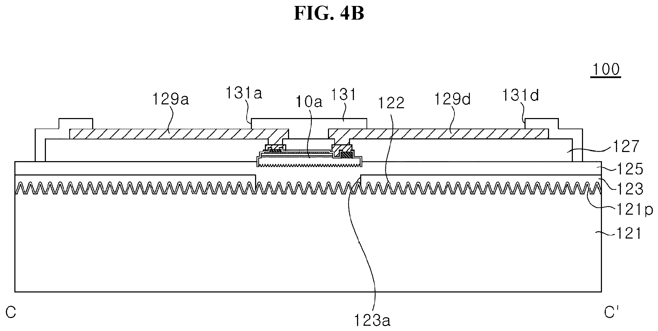

The unit pixels 100 are bonded to the circuit board 1001 through a bonding material. For example, the bonding material may be solder, and after a solder paste is disposed on the pads on the circuit board 1001 using a technology such as screen printing, the unit pixel 100 and the circuit board 1001 may be bonded through a reflow process. A specific configuration of the unit pixels 100 will be described in detail later with reference to FIGS. 4A and 4B.

The molding member 1003 covers the unit pixels 100. The molding member 1003 may contact the surface of the circuit board 1001 and may cover upper surfaces of the unit pixels 100. In addition, the molding member 1003 may have a flat upper surface. In particular, unlike a prior art, a concave portion is not formed on a region between the unit pixels 100.

In some forms, the molding member 1003 may be formed using an ultraviolet-curable resin. Since the ultraviolet-curable resin is used, it is possible to increase hardness of the molding member 1003 compared to a thermosetting resin. The molding member 1003 may be formed of, for example, a dry-film type solder resist (DFSR), a photoimageable solder resist (PSR), a black material (BM), or the like. The molding member 1003 may improve contrast of the displaying apparatus 10000 by preventing optical interference between the unit pixels 100. A method of forming the molding member 1003 will be described in detail later.

The anti-glare layer 1005 may cover the molding member 1003. The anti-glare layer 1005 prevents light reflection and relieves eye fatigue of a user. The anti-glare layer 1005 may be formed, for example, by coating a surface of the molding member 1003 after mixing fine particles such as silica, melamine, acryl, or the like with a curable resin into an ink, and may be cured using ultraviolet rays.

In the illustrated exemplary embodiment, the unit pixels 100 may be formed of the light emitting module 1000, and a plurality of light emitting modules 1000 may be mounted on the panel substrate 2100, thereby providing the displaying apparatus 10000. Accordingly, a process yield of the displaying apparatus 10000 may be improved.

FIG. 4A is a schematic plan view illustrating a unit pixel 100 according to an exemplary embodiment, FIG. 4B is a schematic cross-sectional view taken along line C-C' of FIG. 4A.

Referring to FIGS. 4A and 4B, the unit pixel 100 may include a transparent substrate 121, a first, a second, and a third light emitting devices 10a, 10b, and 10c, a surface layer 122, a light blocking layer 123, an adhesive layer 125, a step adjustment layer 127, connection layers 129a, 129b, 129c, and 129d, and an insulation material layer 131

The unit pixel 100 provides a single pixel including the first, second, and third light emitting devices 10a, 10b, and 10c. The first, second, and third light emitting devices 10a, 10b, and 10c emit light of different colors, and the first, second, and third light emitting devices 10a, 10b, and 10c correspond to subpixels, respectively.

The transparent substrate 121 is a light transmissive substrate such as PET, glass substrate, quartz, sapphire substrate, or the like. The transparent substrate 121 is disposed on a light exiting surface of the light emitting module 1000, and light emitted from the light emitting devices 10a, 10b, and 10c is emitted to the outside through the transparent substrate 121. The transparent substrate 121 may have an upper surface and a lower surface. The transparent substrate 121 may include a concave-convex pattern 121p on a surface facing the light emitting devices 10a, 10b, and 10c, that is, the upper surface. The concave-convex pattern 121p scatters light emitted from the light emitting devices 10a, 10b, and 10c to increase a viewing angle. In addition, light emitted from the light emitting devices 10a, 10b, and 10c having different viewing angle characteristics from one another may be emitted at a uniform viewing angle by the concave-convex pattern 121p. As such, it is possible to prevent an occurrence of color difference depending on the viewing angle.

The concavo-convex pattern 121p may be regular or irregular. The concavo-convex pattern 121p may have a pitch of about 3 µm, a diameter of about 2.8 µm, and a height of about 1.8 µm, for example. The concavo-convex pattern 121p may be a pattern generally applied to a patterned sapphire substrate, but the inventive concepts are not limited thereto.

The transparent substrate 121 may also include an anti-reflection coating, may include an anti-glare layer, or may be treated with an anti-glare treatment. The transparent substrate 121 may have a thickness of about 50 µm to about 300 µm for example.

As the transparent substrate 121 is disposed on the light exiting surface, the transparent substrate 121 does not include a circuit. However, the inventive concepts are not limited thereto, and, in some exemplary embodiments, the transparent substrate 121 may include the circuit.

Although a single unit pixel 100 is illustrated to be formed on a single transparent substrate 121, a plurality of unit pixels 100 may be formed on the single transparent substrate 121.

The surface layer 122 covers the concave-convex pattern 121p of the transparent substrate 121. The surface layer 122 may be formed along a shape of the concave-convex pattern 121p. The surface layer 122 may improve adhesion of the light blocking layer 123 and the adhesive layer 125 formed thereon. For example, the surface layer 122 may be formed of a silicon oxide layer. The surface layer 122 may be omitted depending on a type of the transparent substrate 121.

The light blocking layer 123 is formed on the upper surface of the transparent substrate 121. The light blocking layer 123 may contact the surface layer 122. The light blocking layer 123 may include an absorbing material which absorbs light such as carbon black. The light absorbing material may prevent light generated in the light emitting devices 10a, 10b, and 10c from leaking from a region between the transparent substrate 121 and the light emitting devices 10a, 10b, and 10c toward a side surface thereof, and may improve contrast of the display apparatus.

The light blocking layer 123 may have windows 123a, 123b, and 123c for a light path, so that light generated in the light emitting devices 10a, 10b, and 10c is incident on the transparent substrate 121, and for this purpose, the light blocking layer 123 may be patterned to expose the transparent substrate 121 on the transparent substrate 121. Widths of the windows 123a, 123b, and 123c may be narrower than those of the light emitting devices, but the inventive concepts are not limited thereto, and may be greater than or equal to those of the light emitting devices.

The window 123a of the light blocking layer 123 also defines arrangement locations of the light emitting devices 10a, 10b, and 10c. Accordingly, separate arrangement markers for defining the arrangement locations of the light emitting devices 10a, 10b, and 10c may be omitted. However, the inventive concepts are not limited thereto, and the arrangement markers may be provided on the transparent substrate 121 or on the light blocking layer 123 or the adhesive layer 125 so as to provide the locations for arranging the light emitting devices 10a, 10b, and 10c.

The adhesive layer 125 is attached onto the transparent substrate 121. The adhesive layer 125 may cover the light blocking layer 123. The adhesive layer 125 may be attached onto an entire surface of the transparent substrate 121, but the inventive concepts are not limited thereto, and, in some exemplary embodiments, the adhesive layer 125 may be attached to a portion of the transparent substrate 121 to expose a region near an edge of the transparent substrate 121. The adhesive layer 125 is used to attach the light emitting devices 10a, 10b, and 10c to the transparent substrate 121. The adhesive layer 125 may fill the window 123a formed in the light blocking layer 123.

The adhesive layer 125 may be formed as a light-transmitting layer, and transmits light emitted from the light emitting devices 10a, 10b, and 10c. The adhesive layer 125 may be formed using an organic adhesive. For example, the adhesive layer 125 may be formed using a transparent epoxy. In addition, the adhesive layer 125 may include a diffuser such as SiO₂, TiO₂, ZnO, or the like to diffuse light. The light diffusing material prevents the light emitting devices 10a, 10b and 10c from being observed from the light exiting surface.

Meanwhile, the first, second, and third light emitting devices 10a, 10b, and 10c are disposed on the transparent substrate 121. The first, second, and third light emitting devices 10a, 10b, and 10c may be attached to the transparent substrate 121 by the adhesive layer 125. The first, second, and third light emitting devices 10a, 10b, and 10c may be disposed to correspond to the windows 123a, 123b, and 123c of the light blocking layer 123. When the light blocking layer 123 is omitted, arrangement markers may be added to provide arrangement locations of the light emitting devices 10a, 10b, and 10c.

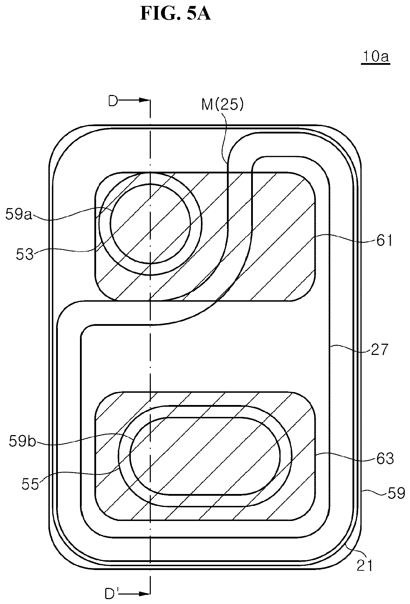

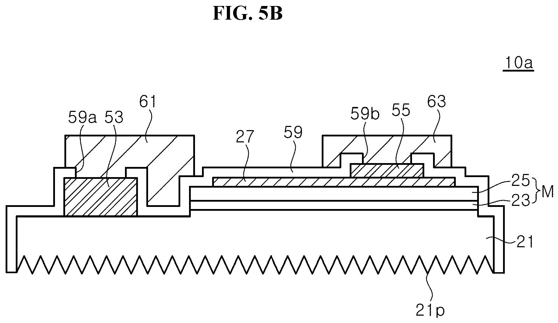

The first, second, and third light emitting devices 10a, 10b, and 10c may be, for example, a red light emitting device, a green light emitting device, and a blue light emitting device. Specific configurations of each of the first, second, and third light emitting devices 10a, 10b, and 10c will be described in detail later with reference to FIGS. 5A and 5B.

The first, second, and third light emitting devices 10a, 10b, and 10c may be arranged in a line, as illustrated in FIG. 4A. In particular, in a case that the transparent substrate 121 is a sapphire substrate, the sapphire substrate may include clean-cut surfaces (e.g., m-plane) and non-clean-cut surfaces (e.g., a-plane) due to a location of a crystal plane along a cutting direction. For example, when the sapphire substrate is cut into a quadrangular shape, two cutting planes on both sides thereof (e.g., m-plane) may be cut cleanly along the crystal plane, and two remaining cutting planes (e.g., a-plane) disposed in a direction perpendicular to the cutting planes may not be cut cleanly. In this case, the clean-cut surfaces of the sapphire substrate 121 may be flush with an arrangement direction of the light emitting devices 10a, 10b, and 10c. For example, in FIG. 4A, the clean-cut surfaces (e.g., m-plane) may be disposed up and down, and the two remaining cut surfaces (e.g., a-plane) may be disposed left and right.

The step adjustment layer 127 covers the first, second, and third light emitting devices 10a, 10b, and 10c. The step adjustment layer 127 has openings exposing electrode pads of the light emitting devices 10a, 10b, and 10c. The step adjustment layer 127 assists to securely form the connection layers by uniformly adjusting elevations of surfaces on which the connection layers 129a, 129b, 129c, and 129d are formed. The step adjustment layer 127 may be formed of, for example, photosensitive polyimide.

The step adjustment layer 127 may be disposed in a region surrounded by an edge of the adhesive layer 125, but the inventive concepts are not limited thereto. For example, the step adjustment layer 127 may be formed to partially expose the edge of the adhesive layer 125.

The first, second, third, and fourth connection layers 129a, 129b, 129c, and 129d are formed on the step adjustment layer 127. The connection layers 129a, 129b, 129c, and 129d may be connected to the electrode pads of the first, second, and third light emitting devices 10a, 10b, and 10c through the openings 127a of the step adjustment layer 127.

In an exemplary embodiment, as illustrated in FIGS. 4A and 4B, the first connection layer 129a may be electrically connected to a second conductivity type semiconductor layer of the first light emitting device 10a, the second connection layer 129b may be electrically connected to a second conductivity of the second light emitting device 10b, the third connection layer 129c may be electrically connected to a second conductivity type semiconductor layer of the third light emitting device 10c, and the fourth connection layer 129d may be commonly electrically connected to first conductivity type semiconductor layers of the first, second, and third light emitting devices 10a, 10b, and 10c. The first, second, third, and fourth connection layers 129a, 129b, 129c, and 129d may be formed together on the step adjustment layer 127, and may include, for example, Au.

In another exemplary embodiment, the first connection layer 129a may be electrically connected to the first conductivity type semiconductor layer of the first light emitting device 10a, the second connection layer 129b may be electrically connected to the first conductivity type semiconductor layer of the second light emitting device 10b, the third connection layer 129c may be electrically connected to the first conductivity type semiconductor layer of the third light emitting device 10c, and the fourth connection layer 129d may be commonly electrically connected to the second conductivity type semiconductor layers of the first, second, and third light emitting devices 10a, 10b, and 10c. The first, second, third, and fourth connection layers 129a, 129b, 129c, and 129d may be formed together on the step adjustment layer 127.

The insulation material layer 131 may be formed to have a thickness smaller than that of the step adjustment layer 127. A sum of the thicknesses of the insulation material layer 131 and the step adjustment layer 127 may be about 1 µm or more and 50 µm or less, but the inventive concepts are not limited thereto.

The insulation material layer 131 covers side surfaces of the step adjustment layer 127 and the connection layers 129a, 129b, 129c, and 129d. In addition, the insulation material layer 131 may cover a portion of the adhesive layer 125. The insulation material layer 131 may have openings131a, 131b, 131c, and 131d exposing the connection layers 129a, 129b, 129c, and 129d, and accordingly, pad regions of the unit pixel 100 may be defined.

In an exemplary embodiment, the insulation material layer 131 may be a translucent material, and may be formed of an organic or inorganic material. The insulation material layer 131 may be formed of, for example, polyimide. When the insulation material layer 131 along with the step adjustment layer 127 is formed of polyimide, all of lower, side, and upper surfaces of the connection layers 129a, 129b, 129c, and 129d may be surrounded by the polyimide, except for the pad regions.

Meanwhile, the unit pixel 100 may be mounted on a circuit board using a bonding material such as solder, and the bonding material may bond the connection layers 129a, 129b, 129c, and 129d exposed to the openings 131a, 131b, 131c, and 131d of the insulation material layer 131 to pads on the circuit board.

According to the illustrated exemplary embodiment, the unit pixel 100 does not include separate bumps, and the connection layers 129a, 129b, 129c, and 129d are used as bonding pads. However, the inventive concepts are not limited thereto, and bonding pads covering the openings 131a, 131b, 131c, and 131d of the insulation material layer 131 may be formed. In an exemplary embodiment, the bonding pads may be formed to partially cover the light emitting devices 10a, 10b, and 10c outside of upper regions of the first, second, third, and fourth connection layers 129a, 129b, 129c, and 129d.

In the illustrated exemplary embodiment, the light emitting devices 10a, 10b, and 10c are described as being attached to the transparent substrate 121 by the adhesive layer 125, but the light emitting devices 10a, 10b, and 10c may be coupled to the transparent substrate 121 using another coupler instead of the adhesive layer 125. For example, the light emitting devices 10a, 10b, and 10c may be coupled to the transparent substrate 121 using spacers, and thus, gas or liquid may be filled in a region between the light emitting devices 10a, 10b, and 10c and the transparent substrate 121. An optical layer that transmits light emitted from the light emitting devices 10a, 10b, and 10c may be formed by the gas or liquid. The adhesive layer 125 described above is also an example of the optical layer. Herein, the optical layer is formed of a material such as gas, liquid, or solid, different from those of the light emitting devices 10a, 10b, and 10c, and thus, is distinguished from the materials of the semiconductor layers in the light emitting devices 10a, 10b, and 10c.

According to the illustrated exemplary embodiment, the unit pixel 100 in which the light emitting devices 10a, 10b, and 10c are arranged on a same plane is provided. The unit pixel 100 may implement light of various colors using the light emitting devices 10a, 10b, and 10c. Hereinafter, the light emitting devices 10a, 10b, and 10c according to an exemplary embodiment will be described in detail.

FIG. 5A is a schematic plan view illustrating the light emitting device 10a according to an exemplary embodiment, and FIG. 5B is a schematic cross-sectional view taken along line D-D' of FIG. 5A. Herein, the light emitting device 10a is exemplarily described, but since the light emitting devices 10b and 10c have a substantially similar structure to that of the light emitting device 10a, repeated descriptions thereof will be omitted.

Referring to FIGS. 5A and 5B, the light emitting device 10a may include a light emitting structure including a first conductivity type semiconductor layer 21, an active layer 23, and a second conductivity type semiconductor layer 25, a contact layer 27, a first contact pad 53, a second contact pad 55, an insulation layer 59, a first electrode pad 61, and a second electrode pad 63.

The light emitting structure, that is, the first conductivity type semiconductor layer 21, the active layer 23, and the second conductivity type semiconductor layer 25 may be grown on a substrate. The substrate may be one of various substrates that are used to grow semiconductors, such as a gallium nitride substrate, a GaAs substrate, a Si substrate, a sapphire substrate, especially a patterned sapphire substrate. The growth substrate may be separated from the semiconductor layers using a process such as a mechanical grinding, a laser lift off, a chemical lift off process, or the like. However, the inventive concepts are not limited thereto, and, in some exemplary embodiments, a portion of the substrate may remain to constitute at least a portion of the first conductivity type semiconductor layer 21.

In an exemplary embodiment, in a case of the light emitting device 10a emitting red light, the semiconductor layers may include aluminum gallium arsenide (AlGaAs), gallium arsenide phosphide (GaAsP), aluminum gallium indium phosphide (AlGaInP), or gallium phosphide (GaP).

In a case of the light emitting device 10b emitting green light, the semiconductor layers may include indium gallium nitride (InGaN), gallium nitride (GaN), gallium phosphide (GaP), aluminum gallium indium phosphide (AlGaInP), or aluminum gallium phosphide (AlGaP).

In an exemplary embodiment, in a case of the light emitting device 10c emitting blue light, the semiconductor layers may include gallium nitride (GaN), indium gallium nitride (InGaN), or zinc selenide (ZnSe).

The first conductivity type and the second conductivity type have opposite polarities, such as when the first conductivity type is an n-type, the second conductivity type becomes a p-type, or, when the first conductivity type is a p-type, the second conductivity type becomes an n-type.

The first conductivity type semiconductor layer 21, the active layer 23, and the second conductivity type semiconductor layer 25 may be grown on the substrate in a chamber using a known process such as metal organic chemical vapor deposition (MOCVD) process. In addition, the first conductivity type semiconductor layer 21 includes n-type impurities (e.g., Si, Ge, and Sn), and the second conductivity type semiconductor layer 25 includes p-type impurities (e.g., Mg, Sr, and Ba). In an exemplary embodiment, the first conductivity type semiconductor layer 21 may include GaN or AlGaN containing Si as a dopant, and the second conductivity type semiconductor layer 25 may include GaN or AlGaN containing Mg as a dopant.

Although the first conductivity type semiconductor layer 21 and the second conductivity type semiconductor layer 25 are shown as single layers in the drawings, these layers may be multiple layers, and may also include a superlattice layer. The active layer 23 may include a single quantum well structure or a multiple quantum well structure, and a composition ratio of a Nitride-based semiconductor may be adjusted to emit a desired wavelength. For example, the active layer 23 may emit blue light, green light, red light, or ultraviolet light.

The second conductivity type semiconductor layer 25 and the active layer 23 may have a mesa M structure and may be disposed on the first conductivity type semiconductor layer 21. The mesa M may include the second conductivity type semiconductor layer 25 and the active layer 23, and may include a portion of the first conductivity type semiconductor layer 21 as shown in FIG. 5B. The mesa M is located on a partial region of the first conductivity type semiconductor layer 21, and a upper surface of the first conductivity type semiconductor layer 21 may be exposed around the mesa M.

In the illustrated exemplary embodiment, the mesa M is formed so as to expose the first conductivity type semiconductor layer 21 around it. In another exemplary embodiment, a through hole may be formed through the mesa M to expose the first conductivity type semiconductor layer 21.

Meanwhile, the first conductivity type semiconductor layer 21 may have a concave-convex pattern 21p by surface texturing. The concave-convex pattern 21p may be formed on a light exiting surface of the first conductivity type semiconductor layer 21. Surface texturing may be carried out by patterning, for example, using a dry or wet etching process.

In an exemplary embodiment, cone-shaped protrusions may be formed, a height of the cone may be about 2 µm to about 3 µm, a distance between the cones may be about 1.5 µm to about 2 µm, and a diameter of a bottom of the cone may be about 3 µm to about 5 µm. The cone may also be truncated, in which an upper diameter of the cone may be about 2 µm to about 3 µm.

In another exemplary embodiment, the concave-convex pattern 21p may include a first concave-convex pattern and a second concave-convex pattern additionally formed on the first concave-convex pattern. The second concave-convex pattern may be formed to have a finer size than that of the first concave-convex pattern.

Since the concave-convex pattern 21p is formed on the surface of the first conductivity type semiconductor layer 21, total internal reflection may be reduced, thereby increasing light extraction efficiency. Surface texturing may be carried out on the first conductivity type semiconductor layers of all of the first, second, and third light emitting devices 10a, 10b, and 10c, and thus, viewing angles of light emitted from the first, second, and third light emitting devices 10a, 10b, and 10c may become uniform. However, the inventive concepts are not limited thereto, and some of the light emitting devices may have a flat surface without including the concave-convex pattern 21p.

The ohmic contact layer 27 is disposed on the second conductivity type semiconductor layer 25 to be in ohmic contact with the second conductivity type semiconductor layer 25. The ohmic contact layer 27 may be formed of a single layer or multiple layers, and may be formed of a transparent conductive oxide film or a metal film. For example, the transparent conductive oxide film may include ITO, ZnO, or the like, and the metal film may include a metal such as Al, Ti, Cr, Ni, Au, or the like and alloys thereof.

The first contact pad 53 is disposed on the exposed first conductivity type semiconductor layer 21. The first contact pad 53 may be in ohmic contact with the first conductivity type semiconductor layer 21. For example, the first contact pad 53 may be formed of an ohmic metal layer in ohmic contact with the first conductivity type semiconductor layer 21. The ohmic metal layer of the first contact pad 53 may be appropriately selected depending on a semiconductor material of the first conductivity type semiconductor layer 21. The first contact pad 53 may be omitted.

The second contact pad 55 may be disposed on the ohmic contact layer 27. The second contact pad 55 is electrically connected to the ohmic contact layer 27. The second contact pad 55 may be omitted.

The insulation layer 59 covers the mesa M, the ohmic contact layer 27, the first contact pad 53, and the second contact pad 55. The insulation layer 59 has openings 59a and 59b exposing the first contact pad 53 and the second contact pad 55. The insulation layer 59 may be formed as a single layer or multiple layers. Furthermore, the insulation layer 59 may include a distributed Bragg reflector in which insulation layers having different refractive indices from one another are stacked. For example, the distributed Bragg reflector may include at least two types of insulation layers selected from SiO₂, Si₃N₄, SiON, TiO₂, Ta₂O₅, and Nb₂O₅.

The distributed Bragg reflector reflects light emitted from the active layer 23. The distributed Bragg reflector may exhibit high reflectance over a relatively wide wavelength range including a peak wavelength of light emitted from the active layer 23, and may be designed in consideration of an incident angle of light. In an exemplary embodiment, the distributed Bragg reflector may have a higher reflectance for light incident at an incident angle of 0 degrees than that for light incident at a different incident angle. In another exemplary embodiment, the distributed Bragg reflector may have a higher reflectance for light incident at a particular incident angle than that for light incident at the incident angle of 0 degrees. For example, the distributed Bragg reflector may have a higher reflectance for light incident at an incident angle of 10 degrees than thar for light incident at the incident angle of 0 degrees.

Meanwhile, the light emitting structure of the blue light emitting device 10c has higher internal quantum efficiency compared to those of the light emitting structures of the red light emitting device 10a and the green light emitting device 10b. Accordingly, the blue light emitting device 10c may exhibit higher light extraction efficiency than those of the red and green light emitting devices 10a and 10b. As such, it may be difficult to properly maintain a color mixing ratio of red light, green light, and blue light.

To adjust the color mixing ratio of red light, green light, and blue light, the distributed Bragg reflectors applied to the light emitting devices 10a, 10b, and 10c may be formed to have different reflectance from one another. For example, the blue light emitting device 10c may have the distributed Bragg reflector having a relatively low reflectance compared to those of the red and green light emitting devices 10a and 10c. For example, the distributed Bragg reflector formed in the blue light emitting device 10c may have a reflectance of 95% or less at the incident angle of 0 degrees for blue light generated in the active layer 23, and further 90% or less, the distributed Bragg reflector formed in the green light emitting device 10b may have a reflectance of about 95% or more and 99% or less at the incident angle of 0 degrees for green light, and the distributed Bragg reflector formed in the red light emitting device 10a may have a reflectance of 99% or more at the incident angle of 0 degrees for red light.

In an exemplary embodiment, the distributed Bragg reflectors applied to the red, green, and blue light emitting devices 10a, 10b, and 10c may have a substantially similar thickness. For example, a difference in thickness between the distributed Bragg reflectors applied to these light emitting devices 10a, 10b, and 10c may be 10% or less of a thickness of a thickest distributed Bragg reflector. By reducing the thickness difference between the distributed Bragg reflectors, process conditions applied to the red, green, and blue light emitting devices 10a, 10b, and 10c, for example, a process of patterning the insulation layer 59, may be similarly set, and furthermore, it is possible to prevent the unit pixel manufacturing process from becoming complex. Moreover, the distributed Bragg reflectors applied to the red, green, and blue light emitting devices 10a, 10b, and 10c may have a substantially similar stacking number. However, the inventive concepts are not limited thereto.

The first electrode pad 61 and the second electrode pad 63 are disposed on the insulation layer 59. The first electrode pad 61 may extend from an upper region of the first contact pad 53 to an upper region of the mesa M, and the second electrode pad 63 may be disposed in the upper region of the mesa M. The first electrode pad 61 may be connected to the first contact pad 53 through the opening 59a, and the second electrode pad 63 may be electrically connected to the second contact pad 55. The first electrode pad 61 may be directly in ohmic contact with the first conductivity type semiconductor layer 21, and in this case, the first contact pad 53 may be omitted. In addition, when the second contact pad 55 is omitted, the second electrode pad 63 may be directly connected to the ohmic contact layer 27.

The first and/or second electrode pads 61 and 63 may be formed of a single layer or a multilayer metal. As a material of the first and/or second electrode pads 61 and 63, metals such as Al, Ti, Cr, Ni, Au, or the like and alloys thereof may be used.

Although the light emitting device 10a according to the exemplary embodiment has been briefly described with reference to the drawings, the light emitting device 10a may further include a layer having additional functions in addition to the above-described layers. For example, various layers such as a reflective layer for reflecting light, an additional insulation layer for insulating a specific element, and a solder preventing layer for preventing diffusion of solder may be further included.

When a flip chip type light emitting device is formed, the mesa may be formed to have various shapes, and locations and shapes of the first and second electrode pads 61 and 63 may also be variously modified, and the second contact pad 55 or the second electrode pad 63 may directly contact the second conductivity type semiconductor layer 25.

In the illustrated exemplary embodiment, the first, second, and third light emitting devices 10a, 10b, and 10c are exemplarily described as the flip chip structure, but the inventive concepts are not limited thereto, and a light emitting device of a lateral structure may be included.

In the description above, the unit pixel 100 including the first, second, and third light emitting devices 10a, 10b, and 10c arranged on the same plane has been described with reference to FIGS. 4A and 4B, but the inventive concepts are not limited thereto. For example, a red LED, a blue LED, and a green LED may be stacked one another to form the unit pixel. Hereinafter, a unit pixel 200 of the stacked structure will be described.

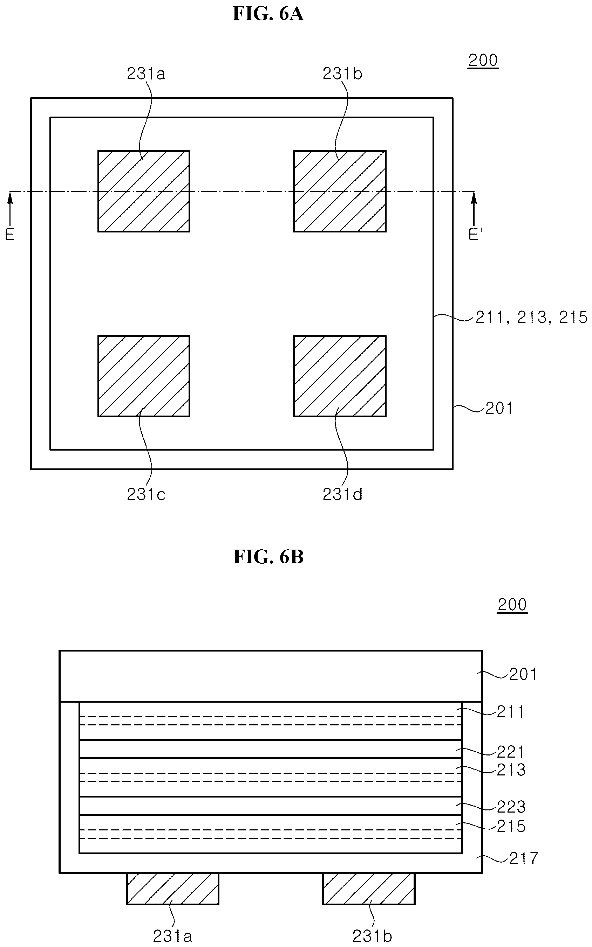

FIG. 6A is a schematic plan view illustrating the unit pixel 200 according to another exemplary embodiment, and FIG. 6B is a schematic cross-sectional view taken along line E-E' of FIG. 6A.

Referring to FIGS. 6A and 6B, the unit pixel 200 according to the exemplary embodiment may include a substrate 201, a first LED stack 211, a second LED stack 213, a third LED stack 215, a first bonding layer 221, a second bonding layer 223, an insulation layer 217, and bonding pads 231a, 231b, 231c, and 231d.

The unit pixel 200 may have an area of 500 µm ×500 µm or less. In other forms, the unit pixel 200 may have an area less than 500 µm ×500 µm, such as 300 µm ×300 µm or less, 200 µm ×200 µm or less, or, 100 µm ×100 µm or less. Since the first, second, and third LED stacks 211, 213, and 215 are stacked in a vertical direction, an external size of the unit pixel 200 may be reduced.

The substrate 201 may be a transparent substrate capable of transmitting light. In some exemplary embodiments, the substrate 201 may be formed to transmit light of a selected specific wavelength or to transmit a portion of light of a specific wavelength. The substrate 201 may be a growth substrate for growing a semiconductor layer, for example, a growth substrate used for epitaxial growth of the first LED stack 211 such as a sapphire substrate. The substrate 201 is not limited to a growth substrate or a sapphire substrate, and may include various other transparent substrates. For example, the substrate 201 may include glass, quartz, an organic polymer, or an organic-inorganic composite material, for example, silicon carbide (SiC), gallium nitride (GaN), indium gallium nitride (InGaN). ), aluminum gallium nitride (AlGaN), aluminum nitride (AlN), gallium oxide (Ga2O3), or a silicon substrate. Further, the substrate 201 may include irregularities, and may be, for example, a patterned sapphire substrate. Since the substrate 201 includes the irregularities, extraction efficiency of light generated in the first LED stack 211 in contact with the substrate 201 may be increased. The irregularities of the substrate 201 may be included to selectively increase luminous intensity of the first LED stack 211 compared to that of the second LED stack 213 or the third LED stack 215. Meanwhile, in another exemplary embodiment, the substrate 201 may be removed. When the substrate 201 is removed, it is not required that the substrate 201 is a transparent substrate.

The first, second and third LED stacks 211, 213, and 215 are configured to emit light toward the substrate 201. Accordingly, light emitted from the third LED stack 215 may pass through the first and second LED stacks 211 and 213. According to an exemplary embodiment, the first, second, and third LED stacks 211, 213, and 215 may emit light having different peak wavelengths from one another. In an exemplary embodiment, an LED stack far from the substrate 201 may reduce light loss by emitting light of a longer wavelength than that of an LED stack close to the substrate 201. For example, the first LED stack 211 may emit blue light, the second LED stack 213 may emit green light, and the third LED stack 215 may emit red light.

In another exemplary embodiment, the second LED stack 213 may emit light having a shorter wavelength than that of the first LED stack 211. Accordingly, it is possible to reduce luminous intensity of the second LED stack 213 emitting light of a relatively short wavelength, and increase luminous intensity of the first LED stack 211 emitting light of a relatively long wavelength, which may be used to adjust a luminous intensity ratio of light emitted from the first, second, and third LED stacks. For example, the first LED stack 211 may be configured to emit green light, the second LED stack 213 may be configured to emit blue light, and the third LED stack 215 may be configured to emit red light. Accordingly, luminous intensity of blue light may be relatively reduced, and luminous intensity of green light may be relatively increased, and thus, the luminous intensity ratio of red, green, and blue may be easily adjusted to be close to, for example, 3:6: 1.

Each of the first, second, and third LED stacks 211, 213, and 215 includes a first conductivity type semiconductor layer, an active layer, and a second conductivity type semiconductor layer. Since the first conductivity type semiconductor layer, the active layer, and the second conductivity type semiconductor layer are similar to those described with reference to FIGS. 5A and 5B, detailed descriptions thereof are omitted to avoid redundancy.

The first, second, and third LED stacks 211, 213, and 215 are grown on different growth substrates from one another, and thereafter, bonded to one another using the first bonding layer 221 and the second bonding layer 223.

The first bonding layer 221 is disposed between the first LED stack 211 and the second LED stack 213, and the second bonding layer 223 is disposed between the second LED stack 213 and the third LED stack 215. The first and second bonding layers 221 and 223 may include a non-conductive material that transmits light. For example, the first and second bonding layers 221 and 223 may include an optically transparent adhesive (OCA), for example, epoxy, polyimide, SU8, spin-on-glass (SOG), Benzocyclobutene (BCB), but the inventive concepts are not limited thereto.

The insulation layer 217 may cover the first, second, and third LED stacks 211, 213, and 215. The insulation layer 217 may protect the first, second, and third LED stacks 211, 213, and 215 from an external environment. The insulation layer 217 may be formed of, for example, a silicon oxide layer or a silicon nitride layer.

Bonding pads 231a, 231b, 231c, and 231d may be disposed on the insulation layer 217. The bonding pads 231a, 231b, 231c, and 231d are electrically connected to the first, second, and third LED stacks 211, 213, and 215. The first, second, third, and fourth bonding pads 231a, 231b, 231c, and 231d may be electrically connected to the first, second, and third LED stacks 211, 213, and 215 through various connection structures, such as vias.

In an exemplary embodiment, the first bonding pad 231a may be electrically connected to the second conductivity type semiconductor layer of the first LED stack 211, the second bonding pad 231b may be electrically connected to the second conductivity type semiconductor layer of the second LED stack 213, the third bonding pad 231c may be electrically connected to the second conductivity type semiconductor layer of the third LED stack 215, and the fourth bonding pad 231d may be commonly electrically connected to the first conductivity type semiconductor layers of the first, second, and third LED stacks 211, 213, and 215.

In another exemplary embodiment, the first bonding pad 231a may be electrically connected to the first conductivity type semiconductor layer of the first LED stack 211, the second bonding pad 231b may be electrically connected to the first conductivity type semiconductor layer of the second LED stack 213, the third bonding pad 231c may be electrically connected to the first conductivity type semiconductor layer of the third LED stack 215, and the fourth bonding pad 231d may be commonly electrically connected to the second conductivity type semiconductor layers of the first, second, and third LED stacks 211, 213, and 215.

The unit pixel 200 according to the illustrated exemplary embodiment may be manufactured as the light emitting module 1000 in place of the unit pixel 100 described above.

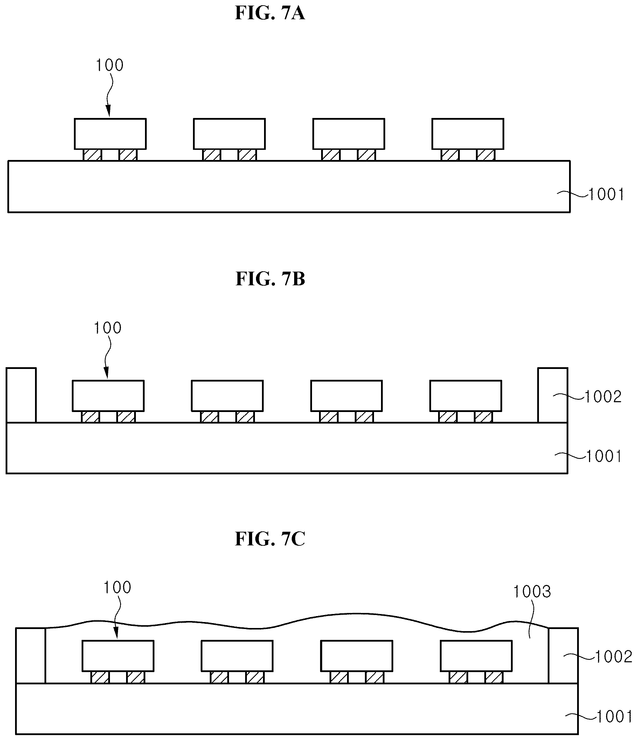

FIGS. 7A through 7F are schematic cross-sectional views illustrating a method of fabricating a light emitting module according to an exemplary embodiment.

Referring to FIG. 7A, unit pixels 100 are bonded on a circuit board 1001. The unit pixels 100 may be arranged at regular intervals. The unit pixels 100 may be bonded onto the circuit board 1001 through, for example, a reflow process. In the illustrated exemplary embodiment, the unit pixels 100 are described as being bonded on the circuit board 1001, but the unit pixels 200 may be bonded.

Referring to FIG. 7B, a dam 1002 is formed near an edge of the circuit board 1001. The dam 1002 may be formed higher than the unit pixels 100. The dam 1002 may be formed, for example, to surround the unit pixels 100 along the edge of the circuit board 1001, but the inventive concepts are not limited thereto. For example, a plurality of dams 1002 spaced apart from one another may be arranged apart from one another near the edges of the circuit board 1001 in a dotted line shape, or may be an auxiliary device that can be coupled to the circuit board 1001, for example, a jig-shaped dam.

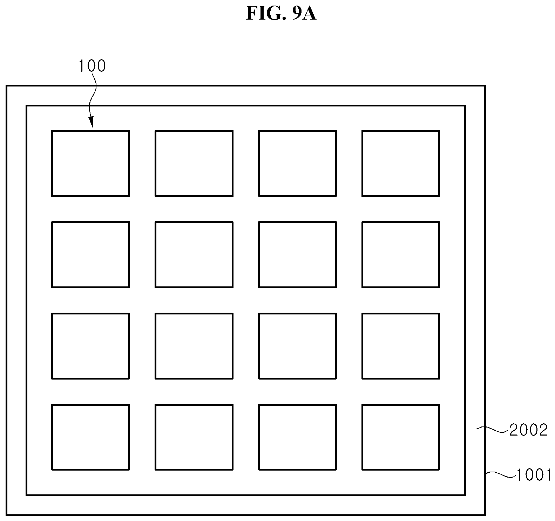

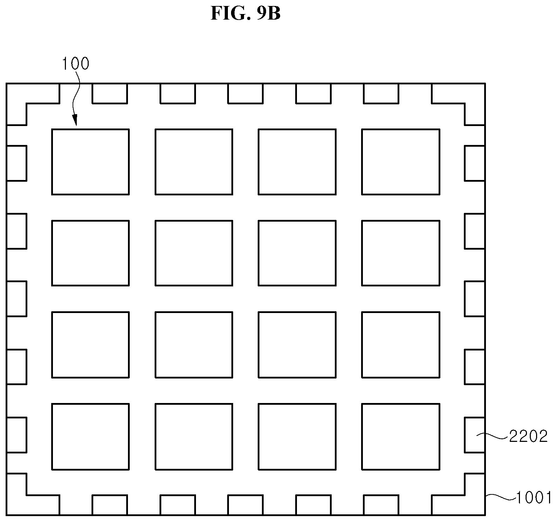

FIG. 9A illustrates a schematic plan view illustrating a light emitting module having a continuous dam structure according to an exemplary embodiment. In some forms, the continuous dam structure 2002 surrounds the circuit board 1001. FIG. 9B illustrates a schematic plan view illustrating a light emitting module having a discontinuous dam structure according to another exemplary embodiment. In other forms, a discontinuous dam structure 2202 surrounds the circuit board 1001 at a predetermined interval. The discontinuous dam structure 2202 forms a shape of a dotted line.

The dam 1002 may be formed of a material with less delamination and less stress such as a light-transparent resin (OCR), a light-transparent adhesive (OCA), a liquid optically clear adhesive (LOCA), or the like. These may include, for example, acrylic, silicone, or urethane polymers.

Referring to FIG. 7C, a preliminary molding member 1003 is formed by applying a molding material. The preliminary molding member 1003 is formed by dispensing the molding material. The dam 1002 prevents the molding material from escaping out. The molding material may be, for example, an epoxy or silicone containing acrylic, silicone, or urethane polymers, and may include a light absorbing agent or a dye, if necessary. The molding material may be transparent, or may be black, white, or gray.

The preliminary molding member 1003 may fill a region between the unit pixels 100 and may also cover the unit pixels 100.

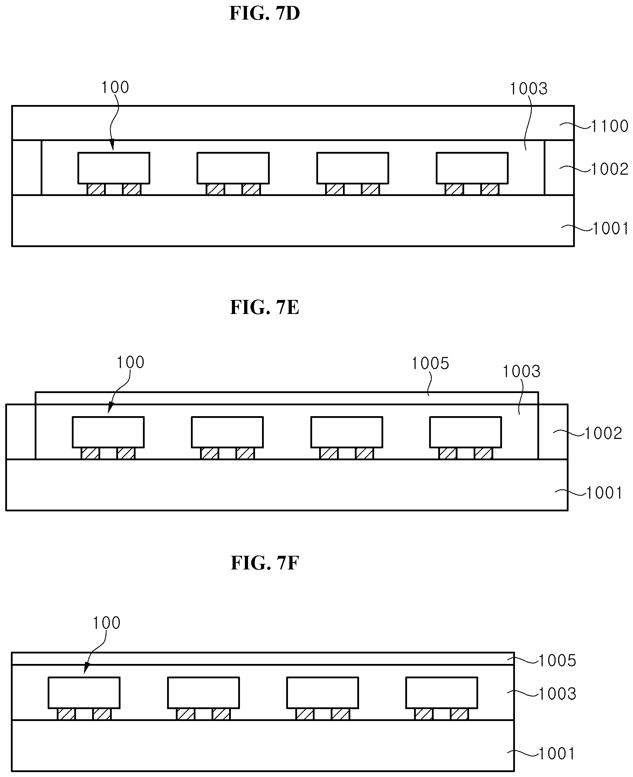

Referring to FIG. 7D, a plate 1100 is placed on the preliminary molding member 1003 and pressure is applied. The plate 1100 may be, for example, a glass substrate, a quartz substrate, or an acrylic substrate.

The plate 1100 may be pressed against the dam 1002, and a shape of the preliminary molding member 1003 is deformed by the plate 1100. A lower surface of the plate 1100 may be a flat surface, and accordingly, the preliminary molding member 1003 is deformed to have a flat upper surface. In another exemplary embodiment, the plate 1100 may have a nano-pattern or a micro-pattern on the lower surface thereof, and thus, the preliminary molding member 1003 may be deformed to have irregularities corresponding to the pattern of the plate 1100.

Subsequently, the molding material may be cured by irradiating ultraviolet rays, and accordingly, the cured molding member 1003 may be formed. Ultraviolet rays may be irradiated through the plate 1100.

Referring to FIG. 7E, the plate 1100 may be removed and an anti-glare layer 1005 may be formed on an exposed surface of the molding member 1003. The anti-glare layer 1005 may be coated using a spray coating technique. Additionally, the anti-glare layer 1005 may be cured using ultraviolet rays.

The anti-glare layer 1005 may prevent glare by including fine particles, for example, silica, melamine, acryl, or the like to scatter light, and may improve surface clarity and softness while maintaining high transmittance.

The anti-glare layer 1005 may include, for example, fine particles such as silica, melamine, and acryl, along with polymers such as acrylic, silicone, and urethane polymers. Anti-glare effect may be adjusted by controlling a density, a size, and a thickness of the anti-glare layer 1005 of the particles. The thickness of the anti-glare layer 1005 may be about 10 µm.

Referring to FIG. 7F, the light emitting module may be completed by cutting and removing the edges of the circuit board 1001 including the dam 1002. The circuit board 1001, the molding member 1003, and the anti-glare layer 1005 may be cut using techniques such as dicing, laser cutting, routing, and the like. As such, a side surface of the circuit board 1001, a side surface of the molding member 1003, and a side surface of the anti-glare layer 1005 may be flush with one another.

According to the illustrated exemplary embodiment, since the molding member 1003 is formed using the plate 1100, the upper surface of the molding member 1003 is formed uniformly over the unit pixels 100 and over the region between the unit pixels 100. Accordingly, it is possible to prevent a concave portion from being formed between the unit pixels 100. Furthermore, since the ultraviolet-curable resin is used, the molding member 1003 having a relatively high hardness may be formed.

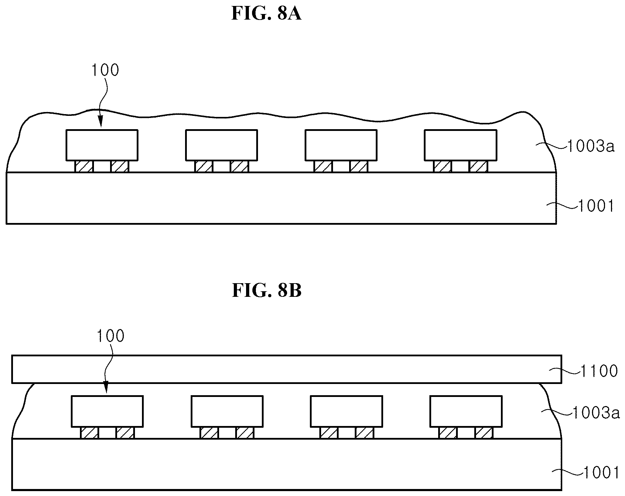

FIGS. 8A through 8D are schematic cross-sectional views illustrating a method of fabricating a light emitting module according to another exemplary embodiment.

Referring to FIG. 8A, the unit pixels 100 are bonded to the circuit board 1001, and a molding material is applied to form a preliminary molding member 1003a. The preliminary molding member 1003a may be formed by dispensing the molding material, and may cover the unit pixels 100. Forming the preliminary molding member 1003a is similar to that described above with reference to FIGS. 7A through 7C, but applying the molding material is carried out without forming the dam 1002.

It takes time for the preliminary molding member 1003a to flow down due to viscosity, and therefore, it is possible to cover the unit pixels 100 by applying a sufficient amount of molding material.

Referring to FIG. 8B, a plate 1100 is placed on the preliminary molding member 1003a and pressure is applied. The plate 1100 may be, for example, a glass substrate, a quartz substrate, or an acrylic substrate.

A shape of the preliminary molding member 1003a is deformed by the plate 1100. The plate 1100 may be lowered to a set height, and thus, the preliminary molding member 1003a may be deformed to a predetermined thickness. Further, a lower surface of the plate 1100 may be a flat surface, and accordingly, the preliminary molding member 1003a is deformed to have a flat upper surface. In another exemplary embodiment, the plate 1100 may have a nano-pattern or a micro-pattern on a lower surface thereof, and thus, the preliminary molding member 1003a may be deformed to have irregularities corresponding to the pattern of the plate 1100.

Subsequently, the preliminary molding member may be cured by irradiating ultraviolet rays, and accordingly, the cured molding member 1003a may be formed. Ultraviolet rays may be irradiated through the plate 1100.

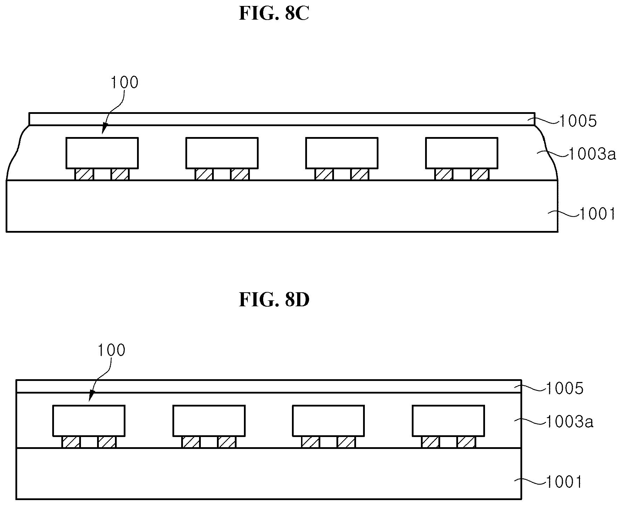

Referring to FIG. 8C, the plate 1100 may be removed and an anti-glare layer 1005 may be formed on an exposed surface of the molding member 1003a. Since the anti-glare layer 1005 has been described with reference to FIG. 7E, a detailed description thereof will be omitted.

Referring to FIG. 8D, the light emitting module may be completed by cutting and removing an edge of the circuit board 1001. The circuit board 1001, the molding member 1003, and the anti-glare layer 1005 may be cut using techniques such as dicing, laser cutting, routing, and the like.

Although some exemplary embodiments have been described herein, it should be understood that these exemplary embodiments are provided for illustration only and are not to be construed in any way as limiting the present disclosure. It should be understood that features or components of one exemplary embodiment can also be applied to other exemplary embodiments without departing from the spirit and scope of the present disclosure.

## Claims

1. A method of fabricating a light emitting module, comprising:
mounting a plurality of unit pixels on a circuit board;
applying a molding material to cover the unit pixels;
placing a plate on the molding material to press the molding material with the plate such that the molding material has a uniform upper surface over the unit pixels and over a region between neighboring unit pixels;
curing the molding material to form a molding member; and
cutting and removing edges of the circuit board and the molding member such that a side surface of the circuit board and a side surface of the molding member are flush with each other.

2. The method of fabricating the light emitting module of claim 1, further comprising:
forming a dam on the circuit board prior to applying the molding material.

3. The method of fabricating the light emitting module of claim 2,
wherein forming the dam further comprises disposing the dam to surround the unit pixels.

4. The method of fabricating the light emitting module of claim 2,
wherein forming the dam further comprises discontinuously disposing the dam along an edge of the circuit board in a dotted line shape.

5. The method of fabricating the light emitting module of claim 1,
wherein curing the molding material further comprises curing the molding material using ultraviolet rays.

6. The method of fabricating the light emitting module of claim 5,
wherein the molding material includes an acrylic resin, a silicone resin, or a urethane resin.

7. The method of fabricating the light emitting module of claim 6,
wherein the molding material includes a light absorbing agent or a dye.

8. The method of fabricating the light emitting module of claim 1,
further comprising forming a nano-pattern or a micro-pattern on a lower surface of the plate.

9. The method of fabricating the light emitting module of claim 1, further comprising:
forming an anti-glare layer on the molding member; and
cutting and removing the edges of the circuit board further comprises cutting and removing an edge of the anti-glare layer such that the side surface of the circuit board, the side surface of the molding member, and a side surface of the anti-glare layer are flush with one another.

10. The method of fabricating the light emitting module of claim 9,
wherein the anti-glare layer includes an acrylic, silicone, or urethane resin and fine particles spread in the resin.

11. The method of fabricating the light emitting module of claim 1,
wherein the unit pixels include at least three light emitting devices arranged on a same plane.

12. The method of fabricating the light emitting module of claim 1,
wherein the unit pixels include a first LED stack, a second LED stack, and a third LED stack stacked in a vertical direction.

13. The method of fabricating the light emitting module of claim 1,
further comprising bonding the unit pixels to the circuit board through a reflow process.

14. The method of fabricating the light emitting module of claim 2, further comprising:
removing the dam by cutting the molding member and the circuit board.

15. Alight emitting module, comprising:
a circuit board;
a plurality of unit pixels mounted on the circuit board;
a molding member covering the unit pixels, and
an anti-glare layer disposed on the molding member,
wherein a side surface of the circuit board, a side surface of the molding member, and a side surface of the anti-glare layer are flush with one another.

16. The light emitting module of claim 15,
wherein the molding member is formed of a uniform material, and has a uniform upper surface over the unit pixels and over a region between neighboring unit pixels.

17. The light emitting module of claim 15,
wherein the unit pixels include a first LED stack, a second LED stack, and a third LED stack in a vertical direction; and
the second LED stack is disposed between the first LED stack and the second LED stack, and emits light having a shorter wavelength than those of the first and third LED stacks.

18. The light emitting module of claim 15,
wherein each of the unit pixels includes four pads.

19. A displaying apparatus, comprising:
a display substrate; and
a plurality of light emitting modules arranged on the display substrate,
each of the light emitting modules comprising:
a circuit board;
a plurality of unit pixels mounted on the circuit board;
a molding member covering the unit pixels; and
an anti-glare layer disposed on the molding member,
wherein a side surface of the circuit board, a side surface of the molding member, and a side surface of the anti-glare layer are flush with one another.

20. The display apparatus of claim 19,
wherein the molding member has a uniform upper surface over the unit pixels and over a region between neighboring unit pixels.
